# EUROPEAN PATENT SPECIFICATION

(11) **EP 3 979 403 B1**
(45) Date of publication and mention of the grant of the patent: **26.11.2025**
(21) Application number: 20890440.9
(22) Date of filing: 18.11.2020
(51) Int. Cl.: H01P 1/208, H05K 1/02, H01Q 1/24

(54) **FILTER ASSEMBLY, ANTENNA APPARATUS AND BASE STATION SYSTEM**
FILTERANORDNUNG, ANTENNENVORRICHTUNG UND BASISSTATIONSSYSTEM
ENSEMBLE FILTRE, APPAREIL D'ANTENNE ET SYSTÈME DE STATION DE BASE

(30) Priority: 21.11.2019 CN 201922024850 U
(43) Date of publication of application: 06.04.2022
(73) Proprietor: ZTE Corporation, Shenzhen, Guangdong 518057 (CN)
(72) Inventor: WU, Zengqiang, Shenzhen, Guangdong 518057 (CN); KANG, Yulong, Shenzhen, Guangdong 518057 (CN); BU, Wei, Shenzhen, Guangdong 518057 (CN); YANG, Feng, Shenzhen, Guangdong 518057 (CN)
(74) Representative: Zoli, Filippo
(86) International application number: PCT/CN2020/129795
(87) International publication number: WO 2021/098726

(56) References cited:
- WO-A1-2013/149347
- CN-A- 109 672 011
- CN-U- 205 122 744
- CN-U- 209 401 808
- CN-U- 209 401 808
- CN-U- 210 403 982
- US-A- 5 036 301
- US-A- 5 448 452
- US-A1- 2006 012 526
- US-A1- 2019 348 734

## Description

### TECHNICAL FIELD

This application relates to the field of communication, and in particular, to a filter assembly, an antenna apparatus, and a base station system.

### BACKGROUND

The rapid development of communication technologies promotes evolution of a communication base station device towards miniaturization, integration, and lightweight. A dielectric filter is widely used in the base station equipment by virtue of good performance, small size, and light weight.

In some cases, a small metal coaxial cavity or a dielectric filter is usually used in a base station system. However, no matter which filter is used, a relatively large machine volume is caused.

US5036301A discloses a filter apparatus comprising a multi-layer printed circuit board on which is mounted a shielded filter having input and output terminals protruding from the printed circuit board. The printed circuit board is formed from two insulating substrates. A connective conductive pattern is formed on an inner surface of one of the substrates that faces the other substrate. Conductive layers are formed on respective outer surfaces of the substrate opposing the connection conductive pattern. At least one of the input and output terminals of the filter is connected to the connective conductive pattern and the conductive layers are grounded, thereby shielding the connective conductive pattern.

US5448452A discloses a circuit board for mounting a band-pass filter. An elongate through hole is formed through the ground surface of the circuit board for shielding the input and output terminals of a band-pass filter from each other. The through hole eliminates unexpected coupling between the input and output terminals within the circuit board. Solder which flows into the through hole allows the casing of the filter to closely contact the ground surface of the circuit board.

US2019/348734A1 discloses a cavity filter having a slim and compact structure in which a push-pin type RF connector, which is formed such that a terminal is exposed to both sides or one side in a height direction, is embedded so as to reduce a size of an antenna system, quickly perform verification for an individual cavity filter while having high reproducibility, and enable the antenna system to be readily mounted.

CN209401808U discloses a dielectric waveguide filter assembly comprising a dielectric waveguide filter, the lower side surface of the dielectric waveguide filter is provided with a first conductive connecting hole and a first non-electroplating area, and the first conductive connecting hole is arranged in the first non-electroplating area; the printed board is connected to the lower side surface of the dielectric waveguide filter; the upper surface of the printed board is provided with a second conductive connecting hole and a second non-electroplating area corresponding to the first non-electroplating area. A third conductive connecting hole and a third non-electroplating area are arranged on the lower surface; wherein a signal transmission line is arranged in the second non-electroplating area, the second conductive connecting hole is formed in the second non-electroplating area, the third conductive connecting hole is formed in the third non-electroplating area, the second conductive connecting hole is electrically connected with the first conductive connecting hole, and the signal transmission line is electrically connected with the second conductive connecting hole and the third conductive connecting hole.

### SUMMARY

In view of this, to at least alleviate the foregoing technical problem to some extent, embodiments of this application provide a filter assembly, an antenna apparatus, and a base station system.

According to an aspect of this application, a filter assembly is provided, including a dielectric support board, on which a filter, a first connector, and a second connector are disposed. An input signal cable is embedded in the dielectric support board. One end of the input signal cable is connected to an input end of the filter, while the other end of the input signal cable is connected to the first connector. An output end of the filter is connected to the second connector through an output signal cable. The filter assembly further includes a signal shielding structure having a shielding cavity, in which the input signal cable and at least a part of the dielectric support board are located. The output signal cable is located outside the shielding cavity in which the input signal cable is located. The first connector is configured to be connected to a power amplification structure, and the second connector is configured to be connected to an antenna structure.

In some embodiments, the signal shielding structure includes a first shielding part which is a metal layer located on a surface of the dielectric support board, and a second shielding part which passes through the dielectric support board and is located between the input signal cable and the output signal cable. The shielding cavity is defined by first shielding part and the second shielding part.

In some embodiments, the dielectric support board is provided with a via hole. The second shielding part includes a metal piece located in the via hole.

In some embodiments, the dielectric support board is provided with a plurality of via holes spaced from each other. The second shielding part includes a plurality of metal pieces respectively located in the plurality of via holes.

In some embodiments, the filter and the first connector are located on a same side of the dielectric support board. The second connector and the filter are respectively disposed on two opposite surfaces of the dielectric support board.

In some embodiments, the output signal cable includes a first transmission part and a second transmission part. The first transmission part passes through the dielectric support board. One end of the first transmission part is connected to the output end of the filter, while the other end of the first transmission part is connected to one end of the second transmission part. The other end of the second transmission part is connected to the second connector. The second transmission part and the second connector are located on a same side of the dielectric support board.

In some embodiments, the output signal cable is located in the dielectric support board. The signal shielding structure has a plurality of shielding cavities. The input signal cable and the output signal cable are located in different shielding cavities.

In some embodiments, the dielectric support board is provided with a mounting hole, in which the second connector is located. The output signal cable includes a third transmission part, a fourth transmission part, a fifth transmission part, and a sixth transmission part that are sequentially connected. The third transmission part is connected to the output end of the filter. The sixth transmission part is connected to the second connector. Both the third transmission part and the fifth transmission part pass through the dielectric support board. Both the sixth transmission part and the filter are disposed on a first surface of the dielectric support board, while the fourth transmission part is disposed on a second surface of the dielectric support board opposite to the first surface.

In some embodiments, a plurality of filters, a plurality of first connectors, and a plurality of second connectors are disposed on the dielectric support board. Both the first connectors and the second connectors are in a one-to-one correspondence with the filters. An input end of each filter is connected to a corresponding first connector through the input signal cable, while an output end of each filter is connected to a corresponding second connector through the output signal cable. The signal shielding structure has a plurality of shielding cavities. The input signal cables connected to different filters are located in different shielding cavities.

In some embodiments, a metal layer is disposed on a surface of the filter.

According to an aspect of this application, an embodiment provides an antenna apparatus, including the antenna structure, the power amplification structure, and the foregoing filter assembly. The first connector of the filter assembly is connected to the power amplification structure, while the second connector of the filter assembly is connected to the antenna structure.

According to an aspect of this application, an embodiment provides a base station system, including the foregoing antenna apparatus.

### BRIEF DESCRIPTION OF DRAWINGS

The accompany drawings are provided for a further understanding of this application, and constitute a part of the description. The accompany drawings and specific implementations below are used to explain this application, but constitute no limitation on this application. In the accompany drawings:
FIG. 1 is a schematic diagram of connections between a metal coaxial cavity and an antenna module and a power amplification module in some cases;
FIG. 2a is a bottom view of a dielectric filter disposed on a phase-shift network in some cases;
FIG. 2b is a cross-sectional view of connections between a dielectric filter and an antenna structure and a power amplification structure in some cases;
FIG. 3a is a cross-sectional view of a first structure of a filter assembly according to an embodiment of this application;
FIG. 3b is a top view of the first structure of the filter assembly according to an embodiment of this application;
FIG. 3c is a perspective diagram of the first structure of the filter assembly according to an embodiment of this application;
FIG. 4 is a cross-sectional view of a second structure of the filter assembly according to an embodiment of this application;
FIG. 5a is a cross-sectional view of a third structure of the filter assembly according to an embodiment of this application;
FIG. 5b is a top view of the third structure of the filter assembly according to an embodiment of this application;
FIG. 5c is a perspective diagram of the third structure of the filter assembly according to an embodiment of this application;
FIG. 6a is a perspective view of a fourth structure of the filter assembly according to an embodiment of this application;
FIG. 6b is another perspective view of the fourth structure of the filter assembly according to an embodiment of this application; and
FIG. 7 is a schematic structural diagram of an antenna apparatus according to an embodiment of this application.

### DETAILED DESCRIPTION

The following describes specific implementations of this application in detail in conjunction with the accompany drawings. It should be understood that the described specific implementations herein are merely used to describe and explain this application, but are not used to limit this application.

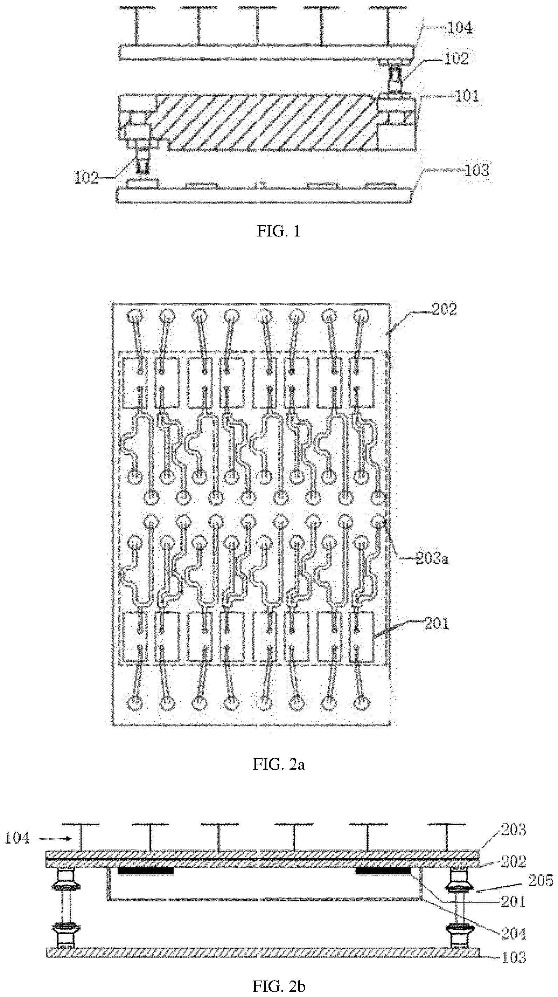

A filter, as an important structure in a base station system, is connected between an antenna module and a power amplification module. The filter may be a small metal coaxial cavity or a dielectric filter. FIG. 1 is a schematic diagram of connections between a metal coaxial cavity and an antenna module and a power amplification module in some cases. As shown in FIG. 1, a metal coaxial cavity 101 is connected to a power amplification structure 103 and an antenna structure 104 through a connector 102 disposed on the metal coaxial cavity 101. However, due to a relatively large weight and volume of the metal coaxial cavity 101, both the volume and weight of a whole machine are relatively large, which makes it difficult to improve competitiveness of the base station system. FIG. 2a is a bottom view of a dielectric filter disposed on a phase-shift network in some cases. FIG. 2b is a cross-sectional view of connections between a dielectric filter and an antenna structure and a power amplification structure in some cases. With reference to FIG. 2a and FIG. 2b, a dielectric filter 201 is directly mounted to a surface of a phase-shift network 202, is connected to an antenna structure 104 by the phase-shift network 202 and a feed layer 203, and is connected to a power amplification structure 103 by the phase-shift network 202 and a connection structure 205. In FIG. 2a, the element 203a is an input end of the feed layer 203. In FIG. 2a, a dashed-line box is the boundary of a metal shielding cover. In order to prevent a spurious signal of the power amplification structure 103 from being too strong and affecting performance of the dielectric filter 201, a metal shielding cover 204 is added. However, the metal shielding cover 204 increases a volume of the whole machine.

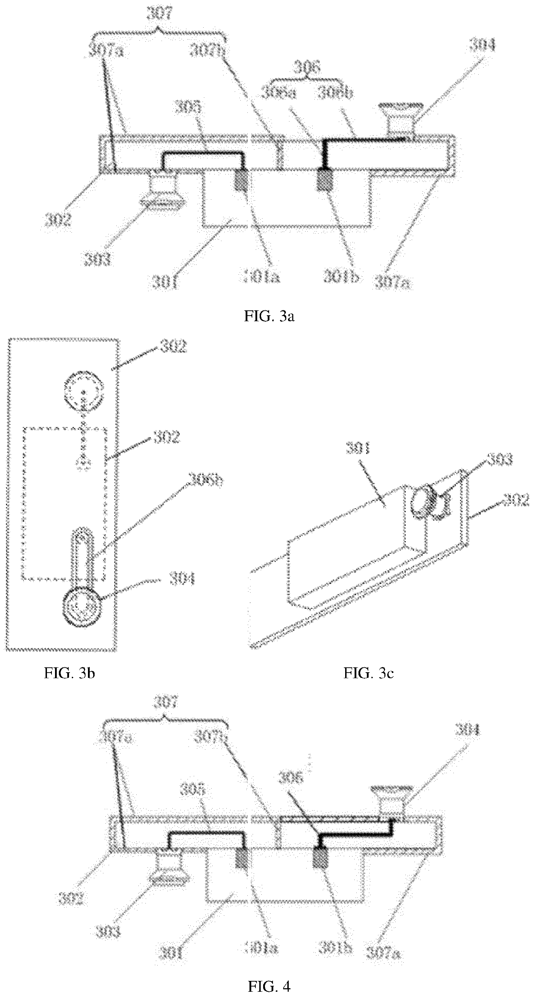

In an aspect of this application, a filter assembly is provided. FIG. 3a is a cross-sectional view of a first structure of a filter assembly according to an embodiment of this application. FIG. 3b is a top view of the first structure of the filter assembly according to an embodiment of this application. FIG. 3c is a perspective view of the first structure of the filter assembly according to an embodiment of this application. With reference to FIG. 3a to FIG. 3c, the filter assembly includes a dielectric support board 302. A filter 301, a first connector 303, and a second connector 304 are disposed on the dielectric support board 302. An input signal cable 305 is disposed in the dielectric support board 302. One end of the input signal cable 305 is connected to an input end 301a of the filter 301, and the other end of the input signal cable 305 is connected to the first connector 303. The first connector 303 is configured to connect a power amplification structure. An output end 301b of the filter 301 is connected to the second connector 304 through an output signal cable 306. The filter assembly further includes a signal shielding structure 307 having a shielding cavity, in which the input signal cable 305 and at least a part of the dielectric support board 302 are located. The output signal cable 306 is located outside the shielding cavity in which the input signal cable 305 is located. For example, the signal shielding structure 307 has a plurality of shielding cavities, and the output signal cable 306 and the input signal cable 305 are located in different shielding cavities. Alternatively, the output signal cable 306 is not located in any shielding cavity. The filter 301 may be located outside the shielding cavity.

It should be noted that the shielding cavity of the signal shielding structure 307 is not empty, but may be filled with the at least a part of the dielectric support board 302.

A material of the dielectric support board 302 is not particularly limited, provided that the material is a dielectric material. In an embodiment, the dielectric support board 302 may be a printed circuit board (PCB), or a plastic board. In an implementation of this application, the dielectric support board 302 is a plastic board, so as to reduce costs. In the actual production, the input signal cable 305 may be embedded in the dielectric support board 302 through integral injection molding.

The filter 301 may particularly be a dielectric filter 301, and is disposed on a first surface of the dielectric support board 302 by means of a surface mount technology (SMT). Both the input end 301a and the output end 301b of the filter 301 are faced to the dielectric support board 302.

In an embodiment of this application, the input end 301a of the filter 301 receives an output signal of the power amplification structure through the input signal cable 305 and the first connector 303. Because the input signal cable 305 is located in the shielding cavity of the signal shielding structure 307, and the output signal cable 306 is located outside the shielding cavity in which the input signal cable 305 is located, a relatively strong spurious signal output by the power amplification structure can be prevented from being directly leaked from space to output of the filter 301, so as to prevent degradation of isolation of input and output of the filter, thereby protecting performance of the filter 301 from being affected. In addition, because the input signal cable 305 is embedded in the dielectric support board 302, and the at least a part of the dielectric support board 302 is located in the shielding cavity, the part of the dielectric support board 302 located in the shielding cavity may space the input signal cable 305 from the signal shielding structure 307, and the signal shielding structure 307 will not occupy excessively extra space outside the dielectric support board 302. For example, the signal shielding structure 307 is configured to enclose the dielectric support board 302 and be attached to a surface of the dielectric support board 302. Alternatively, the signal shielding structure 307 is disposed in the dielectric support board 302. In this way, the volume of the filter assembly is reduced, which in turn reduces the volume of the whole machine structure.

The following describes the first structure of the filter assembly in this embodiment of this application with reference to FIG. 3a to FIG. 3c. As shown in FIG. 3a to FIG. 3c, the input end 301a of the filter 301 is connected to the first connector 303 through the input signal cable 305, and the output end 301b of the filter 301 is connected to the second connector 304 through the output signal cable 306. The first connector 303 of the filter assembly is configured to connect the power amplification structure, and the second connector 304 is configured to connect an antenna structure. Both the first connector 303 and the second connector 304 are common radio frequency connectors. In an implementation of this application, the first connector 303 and the second connector 304 may be ZSMP radio frequency connectors. However, it should be understood that the first connector 303 and the second connector 304 may alternatively be other connectors, and there is no limitation thereto.

The first connector 303 and the filter 301 are located on a same side of the dielectric support board 302, and are both located on the first surface of the dielectric support board 302. The second connector 304 is disposed on a second surface of the dielectric support board 302 opposite to the first surface. The first connector 303, the second connector 304, and the filter 301 may all be disposed on the surfaces of the dielectric support board 302 by means of the surface mount technology.

The input end 301a of the filter 301 is connected to the bottom of the first connector 303 through the input signal cable 305, and the output end 301b of the filter 301 is connected to the bottom of the second connector 304 through the output signal cable 306. A plugging part is provided on top of the first connector 303 and on top of the second connector 304, respectively. The plugging part of the first connector 303 is configured to be connected in a blind-mate manner with a connector of the power amplification structure, and the plugging part of the second connector 304 is configured to be connected in a plugging manner with a connector of the antenna structure. It can be learned that locations of the first connector 303 and the second connector 304 in the filter assembly are the same as the locations of two connectors on the metal coaxial cavity 101 in FIG. 1. In this way, the filter assembly can be used in an antenna apparatus in which the filter 301 is a metal coaxial cavity, and a metal coaxial cavity or a dielectric filter can be used in the whole machine.

The output signal cable 306 may include a first transmission part 306a and a second transmission part 306b. The first transmission part 306a passes through the dielectric support board 302, that is, the first transmission part 306a is a metallization via hole. One end of the first transmission part 306a is connected to the filter 301, the other end of the first transmission part 306a is connected to one end of the second transmission part 306b, and the other end of the second transmission part 306b is connected to the second connector 304. The second transmission part 306b and the second connector 304 are located on a same side of the dielectric support board 302, and both are located on the second surface of the dielectric support board 302. In an embodiment of this application, the second transmission part 306b is in the form of a microstrip line, so as to simplify a processing technology and improve processing precision. The second transmission part 306b in the form of a microstrip line may be manufactured by a laser engraving technology or an etching technology, so as to be surface-mounted on the dielectric support board 302.

The signal shielding structure 307 includes a first shielding part 307a and a second shielding part 307b. The first shielding part 307a is a metal layer located on the surface of dielectric support board 302, which may be formed on the surface of the dielectric support board 302 by an electroplating technology. The second shielding part 307b passes through the dielectric support board 302, and is located between the input signal cable 305 and the output signal cable 306. The shielding cavity is defined by the first shielding part 307a and the second shielding part 307b. The second shielding part 307b may prevent signal interference between the input signal cable 305 and the output signal cable 306.

It should be noted that the shielding cavity is not necessarily completely sealed, provided that the shielding cavity has a signal shielding function.

A metal layer is disposed on a surface of the filter 301. The first shielding part 307a may increase a coverage area as much as possible on the premise that the first shielding part 307a is insulated and spaced from the output signal cable 306, so as to prevent, to some extent, an external signal from interfering with an output signal. As shown in FIG. 3a, the first surface of the dielectric support board 302 is covered by the first shielding part 307a and the filter 301, and the metal layer on the surface of the filter 301 also has the signal shielding function. Therefore, the first shielding part 307 and the filter 301 may also prevent the spurious signal of the power amplification structure from being radiated into the antenna structure. The dielectric support board 302 is provided with a via hole, and the second shielding part 307b includes a metal piece located in the via hole.

In some examples, there are a plurality of via holes that are spaced from each other in order to prevent the dielectric support board from breaking. The second shielding part 307b may include a plurality of metal pieces respectively located in the plurality of via holes. It should be noted that the plurality of via holes are arranged in a direction perpendicular to a paper surface in FIG. 3a. The cross-sectional view shown in FIG. 3a is taken longitudinally at a location of one of the via holes. Therefore, the plurality of via holes are not shown in FIG. 3a. In addition, there is a spacing between adjacent via holes, but it should be understood that the spacing should not be excessively large, so as to ensure a signal shielding function of the second shielding part 307b.

FIG. 4 is a cross-sectional view of a second structure of the filter assembly according to an embodiment of this application. The structure shown in FIG. 4 is similar to the structure shown in FIG. 3a, and the following describes only a difference between the two structures. In the structure shown in FIG. 4, the output signal cable 306 is located in the dielectric support board 302. Both the input signal cable 305 and the output signal cable 306 may be embedded in the dielectric support board 302 in advance by the injection molding technology. In this case, the signal shielding structure 307 may have a plurality of shielding cavities, and the input signal cable 305 and the output signal cable 306 are located in different shielding cavities. In an embodiment, the signal shielding structure also includes the first shielding part 307a and the second shielding part 307b. Different from FIG. 3a, the first shielding part 307a in FIG. 4 has a larger coverage area on the dielectric support board 302. The surface of the dielectric support board 302 except for the areas where the filter 301, the first connector 303, and the second connector 304 are located is covered by the first shielding part 307a. The first shielding part 307a and the second shielding part 307b define a shielding cavity corresponding to the input signal cable 305 and a shielding cavity corresponding to the output signal cable 306.

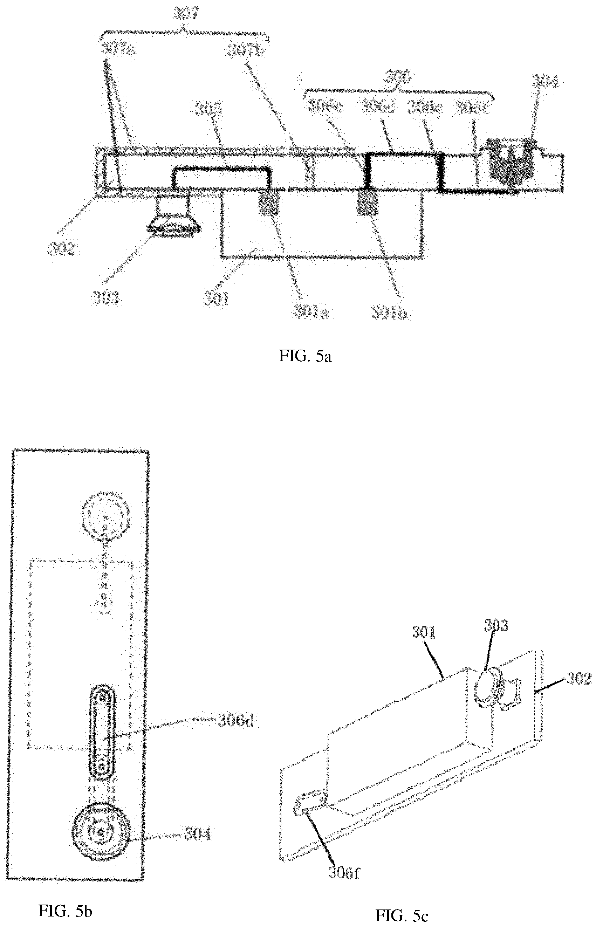

FIG. 5a is a cross-sectional view of a third structure of the filter assembly according to an embodiment of this application. FIG. 5b is a top view of the third structure of the filter assembly according to an embodiment of this application. FIG. 5c is a perspective view of the third structure of the filter assembly according to an embodiment of this application. The third structure of the filter assembly is similar to the foregoing first structure, and the following describes only a difference between the two structures. In the structure shown in FIG. 5a to FIG. 5c, the dielectric support board 302 is provided with a mounting hole, in which the second connector 304 is located in. In an embodiment, the second connector 304 may be embedded in the dielectric support board 302 by the injection molding technology. The output signal cable 306 includes a third transmission part 306c, a fourth transmission part 306d, a fifth transmission part 306e, and a sixth transmission part 306f that are sequentially connected. The third transmission part 306c is connected to the output end 301b of the filter 301, and the sixth transmission part 306f is connected to the second connector 304.

Both the third transmission part 306c and the fifth transmission part 306e pass through the dielectric support board 302. Both the sixth transmission part 306f and the filter 301 are disposed on the first surface of the dielectric support board 302, and the fourth transmission part 306d is disposed on the second surface of the dielectric support board 302 opposite to the first surface. Both the sixth transmission part 306f and the fourth transmission part 306d may be in the form of a microstrip line.

In the structure shown in FIG. 5a to FIG. 5c, the second connector 304 may be implemented by an integrated process of injection molding and electroplating, and the second connector 304 is directly wrapped in molding by an injection molding material, so as to fasten the second connector 304 in the dielectric support board 302. In this manner, surface mount procedures can be reduced, and the costs can be reduced.

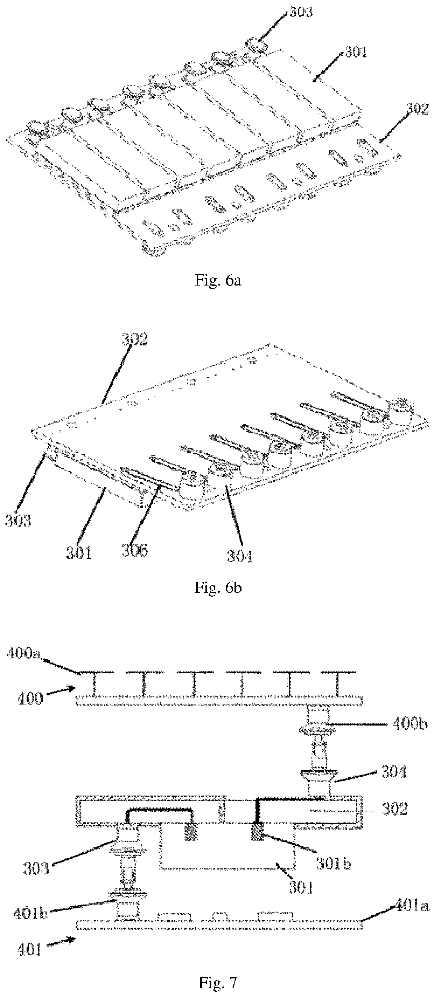

FIG. 6a is a perspective view of a fourth structure of the filter assembly according to an embodiment of this application. FIG. 6b is another perspective view of the fourth structure of the filter assembly according to an embodiment of this application. The fourth structure is similar to the foregoing first structure, and the following describes only a difference between the two structures. In the structures shown in FIG. 6a and FIG. 6b, a plurality of filters 301, a plurality of first connectors 303, and a plurality of second connectors 304 are disposed on the dielectric support board 302. Both the first connectors 303 and the second connectors 304 are in a one-to-one correspondence with the filters 301. An input end of each filter 301 is connected to a corresponding first connector 303 through the input signal cable, and an output end of the each filter 301 is connected to a corresponding second connector 304 through the output signal cable 306. It should be understood that different filters 301 are connected to different input signal cables 305 and different output signal cables.

The input signal cables and the output signal cables may be disposed in any one of the manners shown in FIG. 3a, FIG. 4, and FIG. 5a. Details are not described herein again.

In this case, the signal shielding structure has a plurality of shielding cavities, and input signal cables connected to different filters 301 are located in different shielding cavities, in order to prevent interference between signals received by different filters 301. The shielding cavities may be in a one-to-one correspondence with the filters, so that the input signal cables connected to respective filters are located in corresponding shielding cavities, but the output signal cables are located outside the shielding cavities. Certainly, the number of the shielding cavities may also be set to twice the number of the filters, and both the input signal cable and the output signal cable that are connected to each filter correspond to different shielding cavities. The foregoing second shielding part may be disposed between input signal cables connected to different filters 301.

The filters 301 may be arranged as required, for example, arranged in one row, or arranged in multiple rows and multiple columns. The plurality of filters 301 are disposed on the same dielectric support board 302, and the whole dielectric support board 302 is integrally molded by injection molding. This reduces mold costs, reduces later assembly time of the whole machine, and improves productivity.

In another aspect of this application, an antenna apparatus is provided. FIG. 7 is a schematic structural diagram of an antenna apparatus according to an embodiment of this application. As shown in FIG. 7, the antenna apparatus includes an antenna structure 400, a power amplification structure 401, and the filter assembly provided in the foregoing embodiment. The first connector 303 of the filter assembly is connected to the power amplification structure 401. The antenna structure 400 is configured to receive a signal output by the output end 301b of the filter 301. In an embodiment, the second connector 304 of the filter assembly is connected to the antenna structure 400.

In an embodiment, the power amplification structure 401 may include a power amplification active board 401a and a third connector 401b disposed on the power amplification active board 401a. The antenna structure 400 includes a plurality of antenna units and a fourth connector 400b electrically connected to an antenna unit 400a. The first connector 303 of the filter assembly is connected to the third connector 401b. The second connector 304 of the filter assembly is connected to the fourth connector 400b. The antenna structure 400 and the power amplification structure 401 are located on two opposite sides of the dielectric support board 302, respectively.

It should be understood that the antenna apparatus may further include a phase-shift network (not shown in the figure), which may be disposed on a same signal board as the antenna unit.

In the antenna apparatus provided in the embodiment of this application, the volume of the filter assembly is relatively small, so that the volume of the antenna apparatus can be reduced. In addition, the filters are disposed on the dielectric support board, which will not affect the layout of the phase-shift network, and simplify the design.

In still another aspect of this application, a base station system is provided, including the foregoing antenna apparatus.

In the base station system provided in the embodiment of this application, the volume of the filter assembly is relatively small. Therefore, the volume of the antenna apparatus can be reduced, which in turn reduces the volume of the whole base station system.

In the filter assembly, the antenna apparatus, and the base station system that are provided in the embodiments of this application, because an input signal cable connected to an input end of a filter is located in a shielding cavity of a signal shielding structure, and an output signal cable connected to an output end of the filter is located outside the shielding cavity in which the input signal cable is located, a relatively strong spurious signal output by a power amplification structure can be prevented from directly leaking from space to output of the filter, so as to prevent degradation of isolation of input and output of the filter, thereby protecting performance of the filter from being affected. In addition, because the input signal cable is embedded in a dielectric support board, and at least a part of the dielectric support board is located in the shielding cavity, the part of the dielectric support board located in the shielding cavity may space the input signal cable from the signal shielding structure. Therefore, the signal shielding structure will not occupy excessively extra space outside the dielectric support board. In this way, the volume of the filter assembly is reduced, which in turn reduces the volume of the whole machine structure.

It may be understood that the foregoing implementations are merely example implementations used to describe principles of this application. However, this application is not limited thereto.

## Claims

1. A filter assembly, comprising
a dielectric support board (302) on which a filter (301), a first connector (303), and a second connector (304) are disposed, while an input signal cable (305) being embedded in the dielectric support board (302), one end of the input signal cable (305) being connected to an input end (301a) of the filter (301), the other end of the input signal cable (305) being connected to the first connector (303), an output end (301b) of the filter (301) being connected to the second connector (304) through an output signal cable (306); and
a signal shielding structure (307) having a shielding cavity, in which the input signal cable (305) and at least a part of the dielectric support board (302) are located in the shielding cavity, the output signal cable (306) being located outside the shielding cavity in which the input signal cable (305) is located;
wherein the first connector is configured to be connected to a power amplification structure (103), and the second connector (304) is configured to be connected to an antenna structure (104).

2. The filter assembly of claim 1, wherein the signal shielding structure (307) comprises a first shielding part (307a) which is a metal layer located on a surface of the dielectric support board (302), and a second shielding part (307b) which passes through the dielectric support board (302) and is located between the input signal cable (305) and the output signal cable (306), the shielding cavity being defined by the first shielding part (307a) and the second shielding part (307b).

3. The filter assembly of claim 2, wherein the dielectric support board (302) is provided with a via hole, and the second shielding part (307b) comprises a metal piece located in the via hole.

4. The filter assembly of claim 3, wherein the dielectric support board (302) is provided with a plurality of via holes which are spaced from each other, and the second shielding part (307b) comprises a plurality of metal pieces respectively located in the plurality of via holes.

5. The filter assembly of any one of claims 1 to 4, wherein the filter (301) and the first connector (304) are located on a same side of the dielectric support board (302), while the second connector (303) and the filter (301) are disposed on two opposite surfaces of the dielectric support board (302), respectively.

6. The filter assembly of claim 5, wherein the output signal cable (306) comprises a first transmission part (306a) and a second transmission part (306b), the first transmission part (306a) passing through the dielectric support board (302), one end of the first transmission part (306a) being connected to the output end (301b) of the filter (301), the other end of the first transmission part being connected to one end of the second transmission part, the other end of the second transmission part (306a) being connected to the second connector (304), and the second transmission part (306b) and the second connector (304) being located on a same side of the dielectric support board (302).

7. The filter assembly of claim 5, wherein the output signal cable (306) is located in the dielectric support board (302), the signal shielding structure (307) having a plurality of shielding cavities, and the input signal cable (305) and the output signal cable (306) being located in different shielding cavities.

8. The filter assembly of any one of claims 1 to 4, wherein the dielectric support board (302) is provided with a mounting hole, in which the second connector (304) is located, the output signal cable (306) comprising a third transmission part (306c), a fourth transmission part (306d), a fifth transmission part (306e), and a sixth transmission part (306f) that are sequentially connected, the third transmission part (306c) being connected to the output end (301b) of the filter (301), and the sixth transmission part (306f) being connected to the second connector (304); and
wherein both the third transmission part (306c) and the fifth transmission part (306e) pass through the dielectric support board (302), both the sixth transmission part (306f) and the filter (301) being disposed on a first surface of the dielectric support board (302), and the fourth transmission part (306d) being disposed on a second surface of the dielectric support board (302) opposite to the first surface.

9. The filter assembly of any one of claims 1 to 4, wherein a plurality of filters (301), a plurality of first connectors (303), and a plurality of second connectors (304) are disposed on the dielectric support board (302), both the first connectors (303) and the second connectors (304) being in a one-to-one correspondence with the filters (301), an input end (301a) of each of the plurality of filters (301) being connected to a corresponding first connector (303) through a corresponding input signal cable (305), and an output end (301b) of each of the plurality of filters (301) being connected to a corresponding second connector (304) through a corresponding output signal cable (306); and
wherein the signal shielding structure (307) has a plurality of shielding cavities, and input signal cables (305) connected to different filters (301) being located in different shielding cavities.

10. The filter assembly of any one of claims 1 to 4, wherein a metal layer is disposed on a surface of the filter (301).

11. An antenna apparatus, comprising the antenna structure (104), the power amplification structure (103), and the filter assembly of any one of claims 1 to 10, wherein the first connector (303) of the filter assembly is connected to the power amplification structure (103), while the second connector (304) of the filter assembly is connected to the antenna structure (104).

12. A base station system, comprising the antenna apparatus of claim 11.

## Patentansprüche

1. Filteranordnung, umfassend
eine dielektrische Trägerplatte (302), auf der ein Filter (301), ein erster Verbinder (303) und ein zweiter Verbinder (304) angeordnet sind, während ein Eingangssignalkabel (305) in die dielektrische Trägerplatte (302) eingebettet ist, wobei ein Ende des Eingangssignalkabels (305) mit einem Eingangsende (301a) des Filters (301) verbunden ist, das andere Ende des Eingangssignalkabels (305) mit dem ersten Verbinder (303) verbunden ist, ein Ausgangsende (301b) des Filters (301) über ein Ausgangssignalkabel (306) mit dem zweiten Verbinder (304) verbunden ist; und
eine Signalabschirmungsstruktur (307), die einen Abschirmungshohlraum aufweist, in dem sich das Eingangssignalkabel (305) und mindestens ein Teil der dielektrischen Trägerplatte (302) in dem Abschirmungshohlraum befinden, sich das Ausgangssignalkabel (306) außerhalb des Abschirmungshohlraums befindet, in dem sich das Eingangssignalkabel (305) befindet;
wobei der erste Verbinder konfiguriert ist, um mit einer Leistungsverstärkungsstruktur (103) verbunden zu sein, und der zweite Verbinder (304) konfiguriert ist, um mit einer Antennenstruktur (104) verbunden zu sein.

2. Filteranordnung nach Anspruch 1, wobei die Signalabschirmungsstruktur (307) einen ersten Abschirmungsteil (307a), der eine Metallschicht ist, die sich auf einer Oberfläche der dielektrischen Trägerplatte (302) befindet, und einen zweiten Abschirmungsteil (307b), der durch die dielektrische Trägerplatte (302) verläuft und sich zwischen dem Eingangssignalkabel (305) und dem Ausgangssignalkabel (306) befindet, umfasst, der Abschirmungshohlraum durch den ersten Abschirmungsteil (307a) und den zweiten Abschirmungsteil (307b) definiert ist.

3. Filteranordnung nach Anspruch 2, wobei die dielektrische Trägerplatte (302) mit einem Durchgangsloch versehen ist, und der zweite Abschirmungsteil (307b) ein Metallstück umfasst, das sich in dem Durchgangsloch befindet.

4. Filteranordnung nach Anspruch 3, wobei die dielektrische Trägerplatte (302) mit einer Vielzahl von Durchgangslöchern versehen ist, die voneinander beabstandet sind, und der zweite Abschirmungsteil (307b) eine Vielzahl von Metallstücken umfasst, die sich jeweils in der Vielzahl von Durchgangslöchern befinden.

5. Filteranordnung nach einem der Ansprüche 1 bis 4, wobei sich der Filter (301) und der erste Verbinder (304) auf derselben Seite der dielektrischen Trägerplatte (302) befinden, während der zweite Verbinder (303) und der Filter (301) jeweils auf zwei gegenüberliegenden Oberflächen der dielektrischen Trägerplatte (302) angeordnet sind.

6. Filteranordnung nach Anspruch 5, wobei das Ausgangssignalkabel (306) einen ersten Übertragungsteil (306a) und einen zweiten Übertragungsteil (306b) umfasst, der erste Übertragungsteil (306a) durch die dielektrische Trägerplatte (302) verläuft, ein Ende des ersten Übertragungsteils (306a) mit dem Ausgangsende (301b) des Filters (301) verbunden ist, das andere Ende des ersten Übertragungsteils mit einem Ende des zweiten Übertragungsteils verbunden ist, das andere Ende des zweiten Übertragungsteils (306a) mit dem zweiten Verbinder (304) verbunden ist, und sich der zweite Übertragungsteil (306b) und der zweite Verbinder (304) auf derselben Seite der dielektrischen Trägerplatte (302) befinden.

7. Filteranordnung nach Anspruch 5, wobei sich das Ausgangssignalkabel (306) in der dielektrischen Trägerplatte (302) befindet, die Signalabschirmungsstruktur (307) eine Vielzahl von Abschirmungshohlräumen aufweist, und sich das Eingangssignalkabel (305) und das Ausgangssignalkabel (306) in unterschiedlichen Abschirmungshohlräumen befinden.

8. Filteranordnung nach einem der Ansprüche 1 bis 4, wobei die dielektrische Trägerplatte (302) mit einem Montageloch versehen ist, in dem sich der zweite Verbinder (304) befindet, das Ausgangssignalkabel (306) umfassend einen dritten Übertragungsteil (306c), einen vierten Übertragungsteil (306d), einen fünften Übertragungsteil (306e) und einen sechsten Übertragungsteil (306f), die nacheinander verbunden sind, wobei der dritte Übertragungsteil (306c) mit dem Ausgangsende (301b) des Filters (301) verbunden ist, und der sechste Übertragungsteil (306f) mit dem zweiten Verbinder (304) verbunden ist; und wobei sowohl der dritte Übertragungsteil (306c) als auch der fünfte Übertragungsteil (306e) durch die dielektrische Trägerplatte (302) verlaufen, sowohl der sechste Übertragungsteil (306f) als auch der Filter (301) auf einer ersten Oberfläche der dielektrischen Trägerplatte (302) angeordnet sind, und der vierte Übertragungsteil (306d) auf einer zweiten Oberfläche der dielektrischen Trägerplatte (302) gegenüber der ersten Oberfläche angeordnet ist.

9. Filteranordnung nach einem der Ansprüche 1 bis 4, wobei eine Vielzahl von Filtern (301), eine Vielzahl von ersten Verbindern (303) und eine Vielzahl von zweiten Verbindern (304) auf der dielektrischen Trägerplatte (302) angeordnet sind, sowohl die ersten Verbinder (303) als auch die zweiten Verbinder (304) in einer Eins-zu-Eins-Entsprechung mit den Filtern (301) sind, ein Eingangsende (301a) von jedem der Vielzahl von Filtern (301) über ein entsprechendes Eingangssignalkabel (305) mit einem entsprechenden ersten Verbinder (303) verbunden ist, und ein Ausgangsende (301b) von jedem der Vielzahl von Filtern (301) über ein entsprechendes Ausgangssignalkabel (306) mit einem entsprechenden zweiten Verbinder (304) verbunden ist; und
wobei die Signalabschirmungsstruktur (307) eine Vielzahl von Abschirmungshohlräumen aufweist und sich Eingangssignalkabel (305), die mit verschiedenen Filtern (301) verbunden sind, in verschiedenen Abschirmungshohlräumen befinden.

10. Filteranordnung nach einem der Ansprüche 1 bis 4, wobei eine Metallschicht auf einer Oberfläche des Filters (301) angeordnet ist.

11. Antennenvorrichtung, umfassend die Antennenstruktur (104), die Leistungsverstärkungsstruktur (103) und die Filteranordnung nach einem der Ansprüche 1 bis 10, wobei der erste Verbinder (303) der Filteranordnung mit der Leistungsverstärkungsstruktur (103) verbunden ist, während der zweite Verbinder (304) der Filteranordnung mit der Antennenstruktur (104) verbunden ist.

12. Basisstationssystem, umfassend die Antennenvorrichtung nach Anspruch 11.

## Revendications

1. Ensemble de filtres, comprenant :
une plaque de support diélectrique (302) sur laquelle sont disposés un filtre (301), un premier connecteur (303) et un deuxième connecteur (304), un câble de signal d'entrée (305) intégré dans la plaque de support diélectrique (302), une extrémité du câble de signal d'entrée (305) étant raccordée à une extrémité d'entrée (301a) du filtre (301), l'autre extrémité du câble de signal d'entrée (305) étant connectée au premier connecteur (303), une extrémité de sortie (301b) du filtre (301) étant connectée au deuxième connecteur (304) par l'intermédiaire d'un câble de signal de sortie (306) ; et
une structure de blindage de signal (307) comportant une cavité de blindage, dans laquelle le câble de signal d'entrée (305) et au moins une partie de la plaque de support diélectrique (302) sont situés dans la cavité de blindage, le câble de signal de sortie (306) étant situé à l'extérieur de la cavité de blindage dans laquelle se trouve le câble de signal d'entrée (305);
dans lequel le premier connecteur est configuré pour être connecté à une structure d'amplification de puissance (103), et le deuxième connecteur (304) est configuré pour être connecté à une structure d'antenne (104).

2. Ensemble de filtres selon la revendication 1, dans lequel la structure de blindage de signal (307) comprend une première partie de blindage (307a) constituée d'une couche métallique située sur une surface de la plaque de support diélectrique (302), et une deuxième partie de blindage (307b) qui traverse la plaque de support diélectrique (302) et située entre le câble de signal d'entrée (305) et le câble de signal de sortie (306), la cavité de blindage étant définie par la première partie de blindage (307a) et la deuxième partie de blindage (307b).

3. Ensemble de filtres selon la revendication 2, dans lequel la plaque de support diélectrique (302) est pourvue d'un trou d'interconnexion, et la deuxième partie de blindage (307b) comprend une pièce métallique située dans le trou d'interconnexion.

4. Ensemble de filtres selon la revendication 3, dans lequel la plaque de support diélectrique (302) est pourvue d'une pluralité de trou d'interconnexion espacés les uns des autres, et la deuxième partie de blindage (307b) comprend une pluralité de pièces métalliques situées respectivement dans la pluralité de trous d'interconnexion.

5. Ensemble de filtres selon l'une quelconque des revendications 1 à 4, dans lequel le filtre (301) et le premier connecteur (304) sont situés sur un même côté de la plaque de support diélectrique (302), tandis que le deuxième connecteur (303) et le filtre (301) sont disposés respectivement sur deux surfaces opposées de la plaque de support diélectrique (302).

6. Ensemble de filtres selon la revendication 5, dans lequel le câble de signal de sortie (306) comprend une première partie de transmission (306a) et une deuxième partie de transmission (306b), la première partie de transmission (306a) passant à travers la plaque de support diélectrique (302), une extrémité de la première partie de transmission (306a) étant raccordée à l'extrémité de sortie (301b) du filtre (301), l'autre extrémité de la première partie de transmission étant raccordée à une extrémité de la deuxième partie de transmission, l'autre extrémité de la deuxième partie de transmission (306a) étant connectée au deuxième connecteur (304), et la deuxième partie de transmission (306b) et le deuxième connecteur (304) étant situés du même côté de la plaque de support diélectrique (302).

7. Ensemble de filtres selon la revendication 5, dans lequel le câble de signal de sortie (306) est situé dans la plaque de support diélectrique (302), la structure de blindage de signal (307) comportant une pluralité de cavités de blindage, et le câble de signal d'entrée (305) et le câble de signal de sortie (306) étant situés dans des cavités de blindage différentes.

8. Ensemble de filtres selon l'une quelconque des revendications 1 à 4, dans lequel la plaque de support diélectrique (302) comporte un trou de montage dans lequel est situé le deuxième connecteur (304), le câble de signal de sortie (306) comprenant une troisième partie de transmission (306c), une quatrième partie de transmission (306d), une cinquième partie de transmission (306e) et une sixième partie de transmission (306f) qui sont connectées en séquence, la troisième partie de transmission (306c) étant raccordée à l'extrémité de sortie (301b) du filtre (301), et la sixième partie de transmission (306f) étant connectée au deuxième connecteur (304) ; et
dans lequel la troisième partie de transmission (306c) et la cinquième partie de transmission (306e) traversent toutes les deux la plaque de support diélectrique (302), la sixième partie de transmission (306f) et le filtre (301) étant tous les deux disposés sur une première surface de la plaque de support diélectrique (302), et la quatrième partie de transmission (306d) étant disposée sur une deuxième surface de la plaque de support diélectrique (302) opposée à la première surface.

9. Ensemble de filtres selon l'une quelconque des revendications 1 à 4, dans lequel une pluralité de filtres (301), une pluralité de premiers connecteurs (303) et une pluralité de deuxièmes connecteurs (304) sont disposés sur la plaque de support diélectrique (302), les premiers connecteurs (303) et les deuxièmes connecteurs (304) étant en correspondance biunivoque avec les filtres (301), une extrémité d'entrée (301a) de chacun de la pluralité de filtres (301) étant raccordée à un premier connecteur correspondant (303) par l'intermédiaire d'un câble de signal d'entrée correspondant (305), et une extrémité de sortie (301b) de chacun des multiples filtres (301) étant raccordée à un deuxième connecteur correspondant (304) par l'intermédiaire d'un câble de signal de sortie correspondant (306) ; et
Dans lequel la structure de blindage de signal (307) comprend une pluralité de cavités de blindage, et des câbles de signal d'entrée (305) connectés à différents filtres (301) situés dans différentes cavités de blindage.

10. Ensemble de filtres selon l'une quelconque des revendications 1 à 4, dans lequel une couche métallique est disposée sur une surface du filtre (301).

11. Appareil d'antenne, comprenant une structure d'antenne (104), la structure d'amplification de puissance (103), et l'ensemble de filtres selon l'une quelconque des revendications 1 à 10, dans lequel le premier connecteur (303) de l'ensemble de filtres est connecté à la structure d'amplification de puissance (103), tandis que le deuxième connecteur (304) de l'ensemble de filtres est connecté à la structure d'antenne (104).

12. Système de station de base, comprenant l'appareil d'antenne selon la revendication 11.
